# EUROPÄISCHE PATENTSCHRIFT

(11) **EP 1 383 938 B1**
(45) Veröffentlichungstag und Bekanntmachung des Hinweises auf die Patenterteilung: **05.07.2006**
(21) Anmeldenummer: 02730204.1
(22) Anmeldetag: 24.04.2002
(51) Int. Cl.: C23C 16/02, H01L 21/285

(54) **VERFAHREN ZUM ERZEUGEN EINER METALLISCHEN ODER METALLHALTIGEN SCHICHT**
METHOD FOR PRODUCTION OF A METALLIC OR METAL-CONTAINING LAYER
PROCEDE POUR REALISER UNE COUCHE DE METAL OU CONTENANT DU METAL

(30) Priorität: 30.04.2001 DE 10121132
(43) Veröffentlichungstag der Anmeldung: 28.01.2004
(73) Patentinhaber: Infineon Technologies AG, 81669 München (DE)
(72) Erfinder: SELL, Bernhard, Portland, OR 97210 (US); SÄNGER, Annette, 01099 Dresden (DE); HECHT, Thomas, 01099 Dresden (DE)
(74) Vertreter: Barth, Stephan Manuel
(86) Internationale Anmeldenummer: PCT/EP2002/004521
(87) Internationale Veröffentlichungsnummer: WO 2002/088419

(56) Entgegenhaltungen:
- WO-A-00/06795
- US-A- 5 654 233
- US-A- 6 139 700

## Beschreibung

Verfahren zum Erzeugen einer metallischen oder metallhaltigen Schicht unter Verwendung eines Präkursors auf einer silizium-oder germaniumhaltigen Schicht, insbesondere eines elektronischen Bauelements

Die vorliegende Erfindung betrifft ein Verfahren zum Erzeugen einer metallischen oder metallhaltigen Schicht unter Verwendung eines Präkursors auf einer silizium- oder germaniumhaltigen Schicht, insbesondere eines elektronischen Bauelements gemäß dem Oberbegriff des Anspruchs 1, wie aus der U.S.-A-5,654,233 bekannt.

Aus der WO00/06795 sind ein Verfahren zum Erzeugen einer metallischen Schicht und ein entsprechendes elektronisches Bauelement bekannt, wobei eine Schicht aus amorphem Silizium aufgetragen wird, die das Siliziumoxid-Substrat gegen die korrosive Wirkung des Präkursers WF₆ schützt.

Zum Abscheiden von Metallen auf silizium- oder germaniumhaltigen Substanzen werden häufig Präkursoren, vornehmlich fluorhaltige Präkursoren verwendet. Diese Abscheidetechnik ist hinlänglich bekannt. Nachteilig hierbei ist jedoch, dass manche der hierbei verwendeten Präkursoren, insbesondere die fluorhaltigen Präkursoren mit der silizium- oder germaniumhaltigen Substrat- oder Waferoberfläche reagieren. Bei siliziumhaltigen Substraten entsteht bei Verwendung eines fluorhaltigen Präkursors z.B. flüchtiges SiF₄. Das Substrat wird dabei angeätzt. Sowohl bei der Abscheidung der metallischen oder metallhaltigen Schicht oder Struktur als Metallelektrode für Gates oder Kondensatoren als auch bei der Abscheidung dieser Schicht für Kontaktlochfüllungen führt dies zur Zerstörung der Struktur und damit des elektronischen Bauelements, welches unter Verwendung dieser Schichtstruktur gebildet werden soll.

Der Erfindung liegt damit das Problem zugrunde, ein Verfahren anzugeben, das die Erzeugung einer metallischen oder metallhaltigen Schicht unter Verwendung eines Präkursors ohne die eingangs genannten Nachteile ermöglicht.

Zur Lösung dieses Problems ist ein Verfahren gemäss Anspruch 1 vorgesehen.

Das vorliegende erfindungsgemäße Verfahren schlägt vorteilhaft eine der eigentlichen Schichterzeugung vorausgehende Oberflächenbehandlung der silizium- oder germaniumhaltigen Schichtoberfläche durch Aufbringen einer dünnen Zwischenschicht vor, die die Oberfläche der darunter liegenden Schicht gegen den Angriff der Präkursoren schützt und das Substrat zumindest in dem Bereich, wo der Präkursor angreifen kann, versiegelt. Erfindungsgemäß handelt es sich dabei um eine Schicht, die als Diffusionsbarriere für diejenige chemische Spezies des Präkursors wirkt, welche die Silizium- oder Germaniumätzung verursacht. Weiterhin ist die verwendete Schicht gegenüber dem Angriff der Präkursoren ätzresistent, d.h., sie wird selbst nicht angeätzt. Nach dem Aufbringen dieser "Siegelschicht" kann die eigentliche Schichterzeugung problemlos erfolgen, eine Beeinträchtigung der silizium- oder germaniumhaltigen Schicht, die unter der sehr dünnen Zwischenschicht liegt, ist ausgeschlossen. Für die Metallabscheidung können somit die zur Schichtabscheidung bereits bewährten Präkursoren verwendet werden, ohne dass eine Beeinflussung oder Zerstörung der zu erzeugenden Schichtstruktur oder des Bauelements zu besorgen ist. Weiterhin kann auf bekannte Abscheidetechniken und -tools zurückgegriffen werden, was die Herstellungskosten stark reduziert.

Das erfindungsgemäße Verfahren ermöglicht z.B. die Abscheidung von Metallelektroden auf dünnen Silizium oder Germanium enthaltenden Dielektrika unter Verwendung der Präkursoren. So kann z.B. auf Gate-Oxiden eine sehr dünne Zwischenschicht abgeschieden werden, um anschließend die Metallabscheidung vorzunehmen. Auf diese Weise können die guten Grenzflächeneigenschaften zwischen SiO₂ und dem Substrat bzw. der Bottom-Elektrode bei Verwendung von Metallelektroden beibehalten werden, wenn als Schichtstruktur bzw. Bauelement z.B. eine Kondensatorstruktur hergestellt werden soll.

Eine andere zweckmäßige Einsatzmöglichkeit des erfindungsgemäßen Verfahrens liegt in der Kontaktlochfüllung. Hier kann, da zur Ermöglichung der Metallschichtabscheidung lediglich die sehr dünne Zwischenschicht erforderlich ist, die Leitfähigkeit des Kontaktes zum darunter liegenden Material deutlich verbessert werden.

Um zu vermeiden, dass die Zwischenschicht in irgendeiner Form die Funktionsweise der Schichtstruktur und damit des elektronischen Bauelements beeinflusst ist es zweckmäßig, wenn sie extrem dünn aufgebracht wird. Die Dicke der Zwischenschicht sollte dabei lediglich wenige Atomlagen betragen. Die Dicke sollte im nm-Bereich liegen. Besonders bevorzugt wird dabei die Abscheidung der Zwischenschicht in einem ALD-Verfahren (Atomic Layer Deposition). Mit diesem Verfahren abgeschiedene Schichten garantieren eine sehr gute Schichtuniformität mit extrem niedriger Defektdichte sowie eine exzellente Kantenabdeckung, wobei diese Eigenschaften insbesondere für die Füllung von Kontaktlöchern bzw. die Abscheidung von Metallelektroden in Grabenkondensatoren wesentlich ist. Darüber hinaus bietet die Abscheidung der Zwischenschicht in einem ALD-Verfahren die Möglichkeit der exakten Schichtdickenkontrolle.

Als Zwischenschicht sollte zweckmäßigerweise ein Dielektrikum verwendet werden, wofür sich z.B. Al-, Ta-, Hf-, Ti- oder Zr-Oxide eignen. Weiterhin kann vorgesehen sein, dass eine temperaturstabile Zwischenschicht verwendet wird, die gegenüber nachfolgenden, entweder im Rahmen der Erzeugung der eigentlichen metallischen oder metallhaltigen Schicht oder danach folgenden Temperaturschritten stabil bleibt. Dies ist insbesondere zweckmäßig, wenn wie vorgesehen die Zwischenschicht in einem ihrer Abscheidung nachfolgenden Hochtemperaturschritt stabilisiert wird.

Zweckmäßig ist es ferner, wenn eine Zwischenschicht verwendet wird, die eine Diffusion im Rahmen eines nachfolgenden, der Erzeugung der metallischen oder metallhaltigen Schicht dienenden Silizid-Prozesses ermöglicht. Im Rahmen dieses Prozesses erfolgt die Schichterzeugung durch Abscheidung einer Metallschicht auf der Zwischenschicht und einem anschließenden Diffusionsprozess zur Silizierung des abgeschiedenen Metalls, was hinreichend bekannt ist. Da die Diffusion der beteiligten Komponente(n) durch die Zwischenschicht erfolgt, muss diese zwangsläufig für die diffundierenden Komponenten diffusionsoffen sein.

Neben der Verwendung einer temperaturstabilen Schicht bietet sich auch die Verwendung einer temperaturinstabilen Schicht an, die sich in einem nachfolgenden, gegebenenfalls weiteren Temperaturschritt, insbesondere im Rahmen eines nachfolgenden, der Erzeugung der metallischen oder metallhaltigen Schicht dienenden Silizid-Prozesses zersetzt. Ist die Metallschicht unter Verwendung des Präkursors einmal aufgebracht, so wird die Zwischenschicht, der dann die Funktion einer Opferschicht zukommt, nicht unbedingt mehr benötigt. Schließt sich beispielsweise ein Silizid-Prozess an, so kann die extrem dünne Zwischenschicht innerhalb dieses Prozesses aufgebrochen werden und sich durch die auf ihr abgeschiedene Metallschicht ohne Beeinträchtigung der Funktion der Schichtstruktur verflüchtigen.

Neben dem erfindungsgemäßen Verfahren betrifft die Erfindung ferner ein elektronisches Bauelement, umfassend eine silizium- oder germaniumhaltige Schicht und eine nach dem erfindungsgemäßen beschriebenen Verfahren auf der silizium- germaniumhaltigen Schicht hergestellte metallische oder metallhaltige Schicht.

Das erfindungsgemäße Bauelement zeichnet sich des Weiteren dadurch aus, dass die Zwischenschicht eine Dicke von wenigen Atomlagen aufweist, also sehr dünn ist und in einem ALD-Verfahren aufgebracht ist. Die Zwischenschicht sollte zweckmäßigerweise ein Dielektrikum bevorzugt aus einem Al-, Ta-, Hf-, Ti- oder Zr-Oxid sein und vorzugsweise in einem Temperaturschritt stabilisiert sein.

Schließlich kann vorgesehen sein, dass sich die metallische oder metallhaltige Schicht oberhalb, unterhalb oder beiderseits der Zwischenschicht befindet. Die beiderseitige Schichtausbildung kann insbesondere im Rahmen eines Silizid-Prozesses aufgrund der hierbei gegebenen Diffusionsvorgänge erfolgen.

Weitere Vorteile, Merkmale und Einzelheiten der Erfindung ergeben sich aus den im folgenden beschriebenen Ausführungsbeispielen sowie anhand der Zeichnungen. Dabei zeigen:
- Fig. 1: einen ersten erfindungsgemäßen Schichtaufbau zur Bildung einer Transistorstruktur,
- Fig. 2: einen zweiten erfindungsgemäßen Schichtaufbau zur Bildung einer Kondensatorstruktur,
- Fig. 3: eine Prinzipskizze zur Darstellung Her Herstellung einer Kontaktlochstruktur einer ersten Ausführungsform,
- Fig. 4.: eine Prinzipskizze zur Darstellung der Herstellung einer Kontaktlochstruktur einer zweiten Ausführungsform, und
- Figuren 5a, 5b, 5c: Prinzipskizzen zur Darstellung einer Deep-Trench-Bottomelektrode durch Silizid-Bildung.

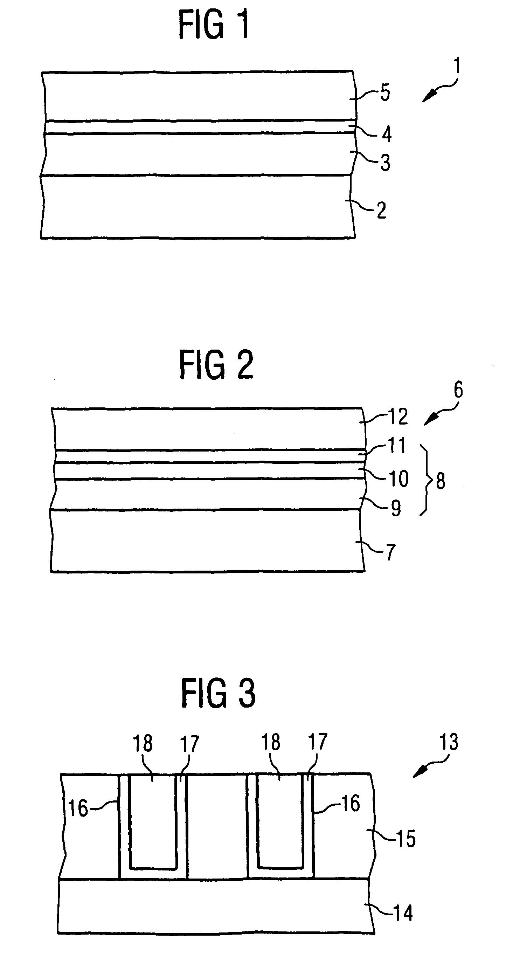

Fig. 1 zeigt einen Ausschnitt eines erfindungsgemäßen Bauelements 1 einer ersten Ausführungsform als Prinzipskizze. Bei diesem Ausführungsbeispiel soll eine Transistorstruktur mit einem Gate-Dielektrikum und Metallelektrode realisiert werden. Hierzu wird auf einem Substrat 2, z.B. Bulk-Si in einem standardmäßigen CMOS-Prozess ein Gate-Dielektrikum 3 erzeugt. Z.B. kann das Substrat zur Bildung von SiO₂ oxidiert oder ein Silikat abgeschieden werden, das dann das Gate-Dielektrikum 3 bildet. Anschließend wird vorzugsweise in einem ALD-Prozess eine Zwischenschicht 4 auf die das Gate-Dielektrikum aufgebracht. Die Zwischenschicht 4 ist z.B. aus Al₂O₃ und ist lediglich wenige Monolagen dick, da die Abscheidung in einem ALD-Prozess sehr defektarm durchgeführt und die Dicke sehr gut kontrolliert werden kann. Nachfolgend kann die Zwischenschicht 4 in einem Hochtemperaturschritt stabilisiert werden.

Nun folgt die Abscheidung der Gate-Elektrode 5 auf der Zwischenschicht 4. Beispielsweise kann es sich bei der Gate-Elektrode um ein wolframhaltiges Gate handeln, wobei WF₆ als Präkursor benutzt werden kann. Der WF₆-Präkursor kann deshalb verwendet werden, da die Zwischenschicht 4 das darunter liegende siliziumhaltige Gate-Dielektrikum 3 "versiegelt". Die Zwischenschicht ist gegen die Fluor-Ionen des WF₆-Präkursors diffusionsdicht. Würde der WF₆-Präkursor direkt auf das Gate-Dielektrikum 3 aufgebracht, so würde ein Ätzangriff unter Bildung von SiF₆ erfolgen und das Gate-Dielektrikum 3 angeätzt werden. Dies wird durch die sehr dünne und defektarme Zwischenschicht 4 vorteilhaft verhindert, so dass derartige aggressive Präkursoren eingesetzt werden können. Daneben ist die Zwischenschicht 4 selbst gegenüber dem verwendeten Präkursor ätzresistent, d.h., sie wird selbst ebenfalls nicht angegriffen.

Als Gate-Elektrode 5 kann entweder W oder WN oder WSiₓ unter Verwendung des Präkursors aufgebracht werden. Der nachfolgende CMOS-Prozess kann standardmäßig durchgeführt werden.

Fig. 2 zeigt ein weiteres Ausführungsbeispiel eines erfindungsgemäßen elektronischen Bauelements 6. Hierbei handelt es sich um eine Kondensatorstruktur, wie sie z.B. in einem Speicherkondensator eines DRAM eingesetzt wird. Die Schichtstruktur bzw. das Bauelement 6 besteht aus einer Bottom-Elektrode 7, die entweder durch starkes Dotieren eines Substrats (z.B. Bulk-Si) gebildet wird, oder die durch zusätzliches Abscheiden von Metall geformt wird. Auf die Bottom-Elektrode 7 wird eine mehrlagige Schichtstruktur 8 zur Bildung eines Node-Dielektrikums aufgebracht. Dieses Dielektrikum besteht im gezeigten Ausführungsbeispiel aus einer Si₃N₄-Schicht 9 und einer auf dieser aufgebrachten SiO₂-Schicht 10. Auf die Schicht 10 wird anschließend die Zwischenschicht 11, auch hier z.B. aus Al₂O₃ in Form weniger Monolagen aufgebracht. Die Schichten 9, 10, 11 bilden zusammen das Node-Dielektrikum. Auch hier erfolgt die Abscheidung der Schicht 11 bevorzugt in einem ALD-Prozess. Anschließend erfolgt die Abscheidung der oberen Metallschicht in Form der Metallelektrode 12, bei der es sich z.B. um eine wolframhaltige Elektrode, die unter Verwendung von WF₆ als Präkursor hergestellt wurde, handeln kann. Auch hier wird ein Angriff des aggressiven WF₆₋Präkursors an der SiO₂-Schicht 10 durch Verwendung der extrem dünnen ätzresistenten Zwischenschicht 11 verhindert. Diese kann auch hier optional durch einen vorhergehenden Hochtemperaturschritt stabilisiert worden sein. Die weitere Integration folgt nach dem bekannten Standardprozess.

Fig. 3 zeigt in Form einer Prinzipskizze ein weiteres Ausführungsbeispiel zur Herstellung einer Kontaktlochstruktur eines Bauelements 13. Auf einem Substrat 14, bevorzugt aus Si wird zunächst eine Oxidschicht 15 erzeugt, in die anschließend Kontaktlöcher 16 geätzt werden. In die Kontaktlöcher 16 wird nachfolgend eine Zwischenschicht 17 sehr geringer Dicke (auch hier wiederum nur wenige Atomlagen) in einem ALD-Prozess abgeschieden. Der ALD-Prozess ist hier insbesondere im Hinblick auf die extrem gute Kantenabdeckung der damit erzeugten Zwischenschicht 17 zweckmäßig. Nach Erzeugung der Zwischenschicht 17 werden die Kontaktlöcher 16 mit metallhaltigem Material 18 gefüllt, z.B. mit WN mit WF₆ als Präkursor, das mittels eines CVD-Verfahren abgeschieden wird. Es ergibt sich also auch hier der erfindungsgemäße Schichtaufbau mit der sehr dünnen, ätzresistenten Zwischenschicht 17. Auch hier erfolgt weder ein Angriff der SiO₂-Schicht 15 noch des darunter liegenden siliziumhaltigen Substrats 14 durch den Präkursor, da dies durch die Zwischenschicht 17 verhindert wird. Ein weiterer Vorteil der mit dem ALD-Verfahren aufgebrachten sehr dünnen Zwischenschicht 17 ist darin zu sehen, dass wie ausgeführt die Schicht 17 extrem dünn abgeschieden werden kann, was für die Leitfähigkeit des Kontaktes vorteilhaft ist.

Nach dem Einbringen des WN-Materials 18 kann in einem nachfolgenden Anneal-Schritt der Stickstoff der WN-Schicht 18 ausgegast werden, so dass das Kontaktloch letztendlich mit weitgehend stickstofffreiem W gefüllt ist.

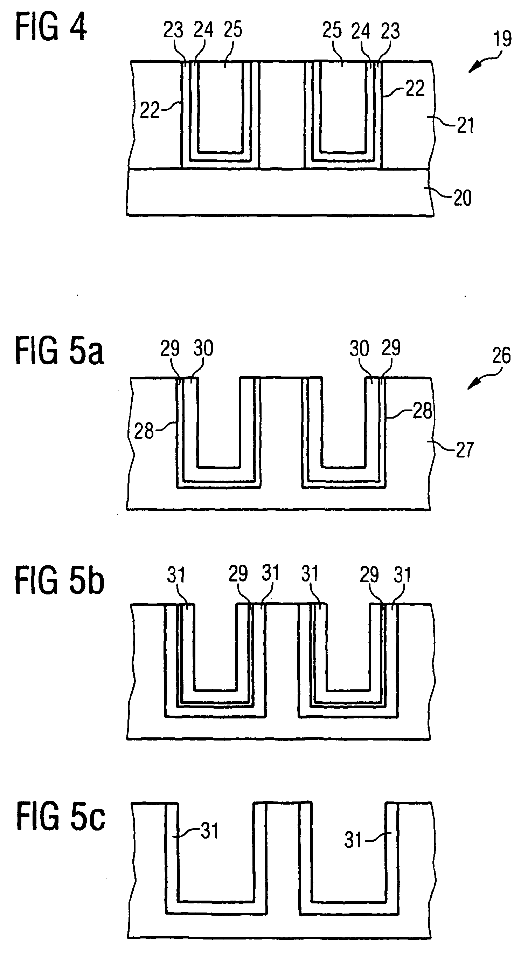

Fig. 4 zeigt eine weitere Ausführungsform eines Bauelements 19, das ebenfalls eine Kontaktlochstruktur zeigt und wie auch das Bauelement 13 aus Fig. 3 aus einem zweckmäßigerweise siliziumhaltigen Substrat 20 sowie einer aufgebrachten siliziumhaltigen Oxidschicht 21 besteht. Nach dem Ätzen der Kontaktlöcher 22 wird auch hier eine Zwischenschicht 23, vorzugsweise Al₂O₃ in einem ALD-Prozess aufgebracht. Anschließend wird das Kontaktloch zunächst mit einer sehr dünnen WN-Schicht 24 unter Verwendung eines WF₆-Präkursors auf der Zwischenschicht 23 abgeschieden, die als Diffusionsbarriere dient, wonach das Kontaktloch mit einer dicken WolframSchicht 25 gefüllt wird. Auch ein solcher Schichtaufbau ist nur aufgrund der Verwendung der extrem dünnen Zwischenschicht 23 möglich.

Schließlich zeigen die Figuren 5a, 5b und 5c ein weiteres erfindungsgemäßes Ausführungsbeispiel eines Bauelements 26. Die Figuren beschreiben die Einführung einer Opferschicht bei der Silizid-Bildung einer Deep-Trench-Bottem-Elektrode des Bauelements 26. In ein vorzugsweise siliziumhaltiges Substrat 27 (gleichermaßen kann auch ein germaniumhaltiges Substrat verwendet werden, was bezüglich der vorbeschriebenen Ausführungsbeispiele gleichermaßen gilt) werden zunächst Gräben 28 geätzt, die anschließend mit einer sehr dünnen, wenige Monolagen dicken Zwischenschicht 29 wandseitig belegt werden. Bei der Zwischenschicht 29 kann es sich hier z.B. um Ta₂O₅ handeln.

Auf die Zwischenschicht 29 wird nachfolgend eine metallische Schicht 30, z.B. aus Wolfram ageschieden. Auch hier verhindert die Zwischenschicht bei der nachfolgenden Abscheidung einer Metallschicht die Reaktion der verwendeten Präkursoren mit dem Substrat 27. In einem nachfolgenden Silizid-Prozess findet nun eine gleichzeitige Diffusion des Wolframs und des Siliziums durch die Zwischenschicht 29 statt, was - siehe Fig. 5a - dazu führt, dass sich auf beiden Seiten der Zwischenschicht 29 eine WSiₓ-Schicht 31 diffusionsbedingt ausbildet. Anschießend kann, wie in Fig. 5c gezeigt, durch selektive Ätzung die obere Silizidschicht 31 abgeätzt werden, wobei in diesem Ätzprozess auch zusätzlich die Zwischenschicht 29 mit entfernt werden kann, so dass letztlich lediglich noch die ausgehend von Fig. 5b unterhalb der Zwischenschicht 29 befindliche Silizid-Schicht 31 verbleibt. Damit wird die Dicke der die Elektrode bildenden Metallschicht deutlich reduziert und der Durchmesser des Grabens wieder vergrößert. Anschließend erfolgt die Abscheidung des Node-Dielektrikums sowie der oberen Top-Elektrode und die weitere standardmäßige Integration.

Anstelle der in den Figuren 5a - 5c gezeigten Ausführungsform ist es auch denkbar, anstatt einer temperaturstabilen Zwischenschicht eine temperaturinstabile Schicht zu wählen, die sich im Rahmen des Silizid-Prozesses zersetzt und dabei aufgebrochen wird und die sich durch die zuvor aufgebrachte Metallschicht verflüchtigt. Ein der Silizidbildung anschließender Ätzprozess dient schließlich lediglich noch zur Reduzierung der Silizidschicht.

Als Substrat, auf welches die Zwischenschicht und schließlich die metallhaltige und metallische Schicht aufzubringen ist, können alle silizium- oder germaniumhaltigen Schichten sowie deren Oxide, Nitride oder Carbide sowie Metallsilizide oder Metallsilikate, die jeweils ebenfalls Si-haltig sind, verwendet werden. Als die Zwischenschicht bildende Dielektrika können z.B. Al₂O₃, Ta₂O₅, HfO₂, TiO₂ oder ZrO₂ in diversen Stöchiometrien eingesetzt werden. Als Metalle sind alle hochschmelzenden Metalle sowie deren Nitride und Silizide wie W, Ti, Ta, Pd, Pt, V, Cr, Zr, Nb, Mo, Hf, Co, Ni, Rh, RhO, Ir sowie andere Metalle wie Al, Cu, Ag, Fe verwendbar. Je nachdem, welches Metall oder welche metallische Schicht aufzubringen ist, wird der entsprechende Präkursor gewählt. Abhängig davon ist dann zweckmäßigerweise auch das jeweilige die Zwischenschicht bildende Dielektrikum hinsichtlich seiner diffusionssperrenden und ätzresistenten Eigenschaften zu wählen.

## Patentansprüche

1. Verfahren zum Erzeugen einer metallischen oder metallhaltigen Schicht unter Verwendung eines Präkursors auf einer silizium- oder germaniumhaltigen Schicht insbesondere eines elektronischen Bauelements, bei dem auf die silizium- oder germaniumhaltige Schicht vor der Verwendung des Präkursors eine Zwischenschicht aufgebracht wird, die zumindest für die Elemente des Präkursors, die die silizium- oder germaniumhaltige Schicht ätzen würden, eine Diffusionsbarriere bildet und selbst gegenüber dem Präkursor ätzresistent ist,
**dadurch gekennzeichnet , dass** die Zwischenschicht in einem ALD-Verfahren in einer Dicke von wenigen Atomlagen aufgebracht wird

2. Verfahren nach Anspruch 1, **dadurch gekennzeichnet, dass** als Zwischenschicht ein Dielektrikum verwendet wird.

3. Verfahren nach Anspruch 2, **dadurch gekennzeichnet, dass** als Dielektrikum ein Al-, Ta-, Hf-, Ti- oder Zr-Oxid verwendet wird.

4. Verfahren nach einem der vorangehenden Ansprüche, **dadurch gekennzeichnet , dass** eine temperturstabile Zwischenschicht verwendet wird.

5. Verfahren nach einem der vorangehenden Ansprüche, **dadurch gekennzeichnet , dass** die Zwischenschicht in einem Temperaturschritt stabilisiert wird.

6. Verfahren nach einem der vorangehenden Ansprüche, **dadurch gekennzeichnet , dass** eine Zwischenschicht verwendet wird, die eine Diffusion im Rahmen eines nachfolgenden, der Erzeugung der metallischen oder metallhaltigen Schicht dienenden Silizid-Prozesses ermöglicht.

7. Verfahren nach Anspruch 6, **dadurch gekennzeichnet, dass** nach Durchführung des Silizid-Prozesses die oberhalb der Zwischenschicht liegende metallische oder metallhaltige Schicht und gegebenenfalls auch die Zwischenschicht insbesondere durch zur Zwischenschicht selektives Ätzen entfernt wird.

8. Verfahren nach einem der Ansprüche 1 bis 3, **dadurch gekennzeichnet , dass** eine temperaturinstabile Schicht verwendet wird, die sich in einem nachfolgenden, gegebenenfalls weiteren Temperaturschritt, insbesondere im Rahmen eines nachfolgenden, der Erzeugung der metallischen oder metallhaltigen Schicht dienenden Silizid-Prozesses zersetzt.

9. Elektronisches Bauelement umfassend eine silizium- oder germaniumhaltige Schicht und eine nach dem Verfahren nach einem der Ansprüche 1 bis 8 auf der silizium- oder germaniumhaltigen Schicht (3, 10, 14, 15, 20, 21, 27) hergestellte metallische oder metallhaltige Schicht (5, 12, 18, 24, 30).

10. Elektronisches Bauelement nach Anspruch 9, **dadurch gekennzeichnet , dass** sich die metallische oder metallhaltige Schicht oberhalb, unterhalb oder beiderseits der Zwischenschicht (4, 11, 17, 23, 29) befindet.

## Claims

1. Method for production of a metallic or metal-containing layer using a precursor on a silicon-or germanium-containing layer of, in particular, an electronic component, in which an intermediate layer is applied to the silicon- or germanium-containing layer before the precursor is used, said intermediate layer forming a diffusion barrier at least for the elements of the precursor which would etch the silicon- or germanium-containing layer and itself being etching-resistant relative to the precursor,
**characterized in that** the intermediate layer is applied with a thickness of a few atomic layers in an ALD method.

2. Method according to Claim 1, **characterized in that** a dielectric is used as the intermediate layer.

3. Method according to Claim 2, **characterized in that** an Al, Ta, Hf, Ti or Zr oxide is used as the dielectric.

4. Method according to one of the preceding claims, **characterized in that** a thermostable intermediate layer is used.

5. Method according to one of the preceding claims, **characterized in that** the intermediate layer is stabilized in a thermal step.

6. Method according to one of the preceding claims, **characterized in that** an intermediate layer is used which enables a diffusion in the context of a subsequent silicide process serving for production of the metallic or metal-containing layer.

7. Method according to Claim 6, **characterized in that**, after the silicide process has been carried out, the metallic or metal-containing layer lying above the intermediate layer and, if appropriate, also the intermediate layer are/is removed in particular by etching which is selective with respect to the intermediate layer.

8. Method according to one of Claims 1 to 3, **characterized in that** a thermally unstable layer is used, which decomposes in a subsequent, if appropriate further thermal step, in particular in the context of a subsequent silicide process serving for production of the metallic or metal-containing layer.

9. Electronic component comprising a silicon- or germanium-containing layer and a metallic or metal-containing layer (5, 12, 18, 24, 30) fabricated on the silicon- or germanium-containing layer (3, 10, 14, 15, 20, 21, 27) by the method according to one of Claims 1 to 8.

10. Electronic component according to Claim 9, **characterized in that** the metallic or metal-containing layer is situated above, below or on both sides of the intermediate layer (4, 11, 17, 23, 29).

## Revendications

1. Procédé pour la production d'une couche métallique ou contenant du métal utilisant un précurseur sur une couche contenant du silicium ou du germanium en particulier un composant électronique dans lequel une couche intermédiaire est appliquée sur la couche contenant du silicium ou du germanium avant l'utilisation du précurseur, la couche intermédiaire formant au moins pour les éléments du précurseur, qui auraient gravé la couche contenant du silicium ou du germanium, une barrière de diffusion et étant elle-même résistante à la gravure du précurseur,
**caractérisé en ce que** la couche intermédiaire est appliquée par un procédé ALD avec une épaisseur de quelques couches atomiques.

2. Procédé selon la revendication 1
**caractérisé en ce qu'**un diélectrique est utilisé comme couche intermédiaire.

3. Procédé selon la revendication 2
**caractérisé en ce qu'**un oxyde d'Al, de Ta, de Hf, de Ti ou de Zr est utilisé comme diélectrique.

4. Procédé selon l'une quelconque des revendications précédentes
**caractérisé en ce qu'**une couche intermédiaire stable en température est utilisée.

5. Procédé selon l'une quelconque des revendications précédentes
**caractérisé en ce que** la couche intermédiaire est stabilisée par une étape thermique.

6. Procédé selon l'une quelconque des revendications précédentes
**caractérisé en ce qu'**on utilise une couche intermédiaire qui permet une diffusion dans le cadre d'un processus de silicidation suivant, servant à la production de la couche métallique ou contenant du métal.

7. Procédé selon la revendication 6
**caractérisé en ce qu'**après la réalisation du processus de silicidation, la couche métallique ou contenant du métal située au-dessus de la couche intermédiaire et, le cas échéant, aussi la couche intermédiaire sont retirées en particulier par gravure sélective jusqu'à la couche intermédiaire.

8. Procédé selon l'une des revendications 1 à 3
**caractérisé en ce qu'**on utilise une couche instable en température, qui se décompose lors d'une, le cas échéant, autre étape thermique suivante, en particulier dans le cadre d'un processus de silicidation suivant, servant à la production de la couche métallique ou contenant du métal.

9. Composant électronique comprenant une couche contenant du silicium ou du germanium et une couche métallique ou contenant du métal (5, 12, 18, 24, 30) fabriquée conformément au procédé selon les revendications 1 à 8 sur la couche contenant du silicium ou du germanium (3, 10, 14, 15, 20, 21, 27).

10. Composant électronique selon la revendication 8,
**caractérisé en ce que** la couche métallique ou contenant du métal se trouve au-dessus, au-dessous ou des deux côtés de la couche intermédiaire (4, 11, 17, 23, 29).
